Europäisches Patentamt

European Patent Office

Office européen des brevets

(11) Veröffentlichungsnummer: **0 064 745**
A2

(12) **EUROPÄISCHE PATENTANMELDUNG**

(21) Anmeldenummer: **82103999.7**

(22) Anmeldetag: **07.05.82**

(51) Int. Cl.³: **H 01 L 21/28**
**H 01 L 29/80**

(30) Priorität: **07.05.81 US 261628**

(43) Veröffentlichungstag der Anmeldung:
**17.11.82 Patentblatt 82/46**

(84) Benannte Vertragsstaaten:
**DE FR GB IT**

(71) Anmelder: **Microwave Semiconductor Corp.**
**100 School House Road**
**Somerset New Jersey(US)**

(72) Erfinder: **Rosenheck, Leonard S.**
**3 Holly Drive**
**Morris Plains New Jersey 07950(US)**

(72) Erfinder: **Drukier, Ira**
**14 Vanderbilt Drive**
**Livingston New Jersey 07039(US)**

(74) Vertreter: **Mehl, Ernst, Dipl.-Ing. et al,**
**Postfach 22 01 76**
**D-8000 München 22(DE)**

(54) **Verfahren zum Herstellen eines Feldeffekttransistors.**

(57) Zum Herstellen eines Feldeffekttransistors werden zunächst Source und Drain, jeweils mit einer ohmschen Metallschicht (2,3,4) bedeckt, auf einem Halbleitersubstrat (1) erzeugt. Dann wird zwischen beiden ein Kanal (5, 6) gebildet. Innerhalb des Kanals (5, 6) wird photolithographisch ein Gate-Gebiet (8, 9) festgelegt. Alle freien Oberflächen werden mit einer Schottky-Metallschicht (10) überzogen. Durch einen weiteren photolithographischen Prozeß wird eine Gate-Öffnung über dem Gate-Gebiet (8, 9) erzeugt. Das Halbleitersubstrat (1) wird dann zur Bildung einer sich vom Gate-Gebiet (8, 9) aus erstreckenden Metallsäule (14, 15) elektroplattiert. Anschließend wird zunächst die zweite Photoresistlackschicht (11) entfernt; dann werden alle Metalle (10, 14, 15) bis zur Freilegung der ersten Photoresistlackschicht (7) abgeätzt, die anschließend entfernt wird. Auf diese Weise können verschiedene Gate-Metall-Systeme verwendet und ein niedriger Gate-Widerstand sowie eine unsymmetrische Source-Gate-Drain-Anordnung ohne Benutzung von Abhebetechniken erzielt werden.

FIG 6

Croydon Printing Company Ltd

Microwave Semiconductor Corp.          Unser Zeichen
Somerset, New Jersey, USA              VPA 81 P 8224 E

– 1 –

## Verfahren zum Herstellen eines Feldeffekttransistors

Die Erfindung betrifft ein Verfahren zum Herstellen eines Feldeffekttransistors mit einem Halbleitersubstrat, das Source und Drain, jeweils mit einer ohmschen Metallschicht bedeckt, einen Kanal zwischen diesen und ein Gate innerhalb des Kanals aufweist.

Zur Erzeugung des Gates innerhalb eines FET-Kanals sind zwei gebräuchliche Methoden bekannt, nämlich die Abhebetechnik (Lift-off-Technik) und die Ionenätztechnik.

Bei der erstgenannten Technik werden Source und Drain auf irgendeine übliche Weise hergestellt. Nachdem ein Kanal gebildet ist, wird die Lage eines Gate-Gebietes mittels einer Photoresisttechnik festgelegt. Dazu wird zunächst eine Photoresistlackschicht aufgebracht und mit einer Maske versehen, die das Gate-Gebiet freiläßt. Anschließend wird belichtet und das unmaskierte Photoresistmaterial entwickelt und abgelöst. Dann wird eine Schicht aus Gate-Metall aufgebracht. Der unbelichtete Photoresistlack unterhalb des Gate-Metalls wird durch ein Lösungsmittel, beispielsweise Azeton, entfernt, wobei auch das gesamte Metall, das den Photoresistlack bedeckt, entfernt wird. Das heißt, das Metall wird abgehoben und Gate-Metall verbleibt nur auf dem Gate-Gebiet.

Dieses Verfahren ist genauer in der US-PS 4 016 643 beschrieben. Es bietet den Vorteil, daß das Gate unsymmetrisch angeordnet werden kann, nämlich näher an der Source als am Drain. Eine solche unsymmetrische Gate-Anordnung, die beispielsweise aus dem US-Patent 4 111 725

Kbr 1 Gae / 06.05.1982

bekannt ist, ermöglicht eine höhere Durchbruchsspannung und folglich eine höhere FET-Leistung. Dieses bekannte Verfahren bietet somit einen erheblichen Vorteil, hat aber auch einige wesentliche Nachteile. Zunächst muß eine Metallschicht an der Grenze zwischen dem Gate-Gebiet und den umgebenden Oberflächen unterbrochen werden. Bei kontinuierlich verlaufenden Schichten würde das Gate wahrscheinlich nicht genau festgelegt werden. Der Photoresistlack muß daher sehr sorgfältig geätzt werden, um eine senkrechte oder negativ geneigte Wand zu erzielen. Aber auch mit geeignet geneigten Wänden kann die Dicke der Metallschicht in der Regel nur zwei Drittel der Dicke der Photoresistlackschicht betragen, die wiederum relativ dünn gehalten werden muß, um Gates in der Größenordnung von einem Mikrometer oder weniger festzulegen. Unter diesen Bedingungen ist es schwierig, glatte Kanten zu erzielen, so daß üblicherweise Aluminium verwendet wird, obwohl Aluminium weniger zuverlässig ist als ein gegen höhere Temperaturen beständiges Metallsystem. Darüberhinaus hat eine geringe Menge von Gate-Metall einen hohen parasitären Gate-Widerstand zur Folge.

Dicke temperaturbeständige Metall-Gates können erzielt werden, indem man die Photoresistlackschicht auf eine oder mehrere Glasschichten aufbringt und das Gate-Gebiet dadurch festlegt, daß man eine Öffnung in diese Mehrlagenschicht-Struktur ätzt, wie es in der obenerwähnten US-PS 4 016 643 beschrieben ist. Jedoch vermehrt ein so kompliziertes Maskierungs- und Ätzverfahren die Schwierigkeiten bei der Festlegung des Gate-Gebietes und ist auch aus wirtschaftlichen Gesichtspunkten nicht günstig.

Bei der zweiten bekannten Technik wird das Gate-Gebiet durch Ionenätzen festgelegt, wobei gleichzeitig auch Source und Drain definiert werden. Nach Anwendung eines geeigneten Ionenätz-Verfahrens wird der Kanal durch chemisches Naßätzen gebildet, bei welchem das Substrat genau unterätzt wird und ein metallischer Überhang verbleibt. Gate-Metall wird dann verdampft und innerhalb des durch die überhängende Metallschicht definierten Gebietes abgeschieden. Dieses Verfahren ist insoweit ziemlich einfach, als es keine besondere Ausrichtung des Gates erfordert. Jedoch hat das Gate von Source und Drain immer den gleichen Abstand. Die erzielbaren Durchbruchsspannungen sind daher nicht so hoch wie bei einer unsymmetrischen Anordnung von Source, Gate und Drain. Außerdem kann nur eine beschränkte Menge von Gate-Metall abgeschieden werden, ohne einen Kurzschluß zu erzeugen.

Eine bekannte Möglichkeit zur Herstellung dickerer Gate-Strukturen ist in der US-PS 3 112 554 beschrieben. Bei dem dort angegebenen Verfahren wird ein zylindrischer Stab aus Halbleitermaterial zunächst im Strahl eines Ätzelektrolyten und dann im Strahl eines Elektroplattierelektrolyten rotieren gelassen, der ein Metallsalz enthält. Das Ätzmittel ätzt ein halsförmiges Gebiet in den Stab und aus der Elektroplattierlösung wird ein metallisches Gate abgeschieden, das den verdünnten Teil des Stabes umgibt und an diesem haftet. Diese Strahl-Elektroplattiertechnik ist jedoch offensichtlich aufwendig und auf die Anwendung bei Bauelementen mit geringer Miniaturisierung beschränkt. Deshalb wird dieses Elektroplattierverfahren nicht in großem Umfang angewendet. Elektrolytische Behandlungen des Gates wurden im Gegenteil zum Zwecke der Abtragung bzw. Anodisierung des Metalls vorgeschlagen, beispielsweise in der US-PS 3 568 305.

Aufgabe der vorliegenden Erfindung ist es, ein verbessertes Verfahren zum Herstellen von Feldeffekttransistoren anzugeben, bei dem insbesondere Abhebetechniken zur Herstellung des Gates nicht erforderlich sind.

Bei dem eingangs erwähnten Verfahren wird dies erfindungsgemäß durch folgende Verfahrensschritte erreicht:

- nach Bildung von Source und Drain mit der ohmschen Metallschicht sowie des Kanals wird eine erste Photoresistlackschicht aufgebracht, das Gate-Gebiet innerhalb des Kanals photolithographisch festgelegt und die Photoresistlackschicht innerhalb des Gate-Gebietes abgeätzt;

- alle offenliegenden Oberflächen werden mit einer Schottky-Metallschicht beschichtet;

- auf die Schottky-Metallschicht wird eine zweite Photoresistlackschicht aufgebracht;

- in der zweiten Photoresistlackschicht wird im Kanal photolithographisch eine auf das Gate-Gebiet ausgerichtete Gate-Öffnung festgelegt und die Photoresistlackschicht dort abgeätzt;

- durch Elektroplattieren des Halbleitersubstrats wird auf der Schottky-Metallschicht innerhalb des Gate-Gebietes eine Metallsäule gebildet;

- die zweite Photoresistlackschicht wird abgelöst;

- die Schottky-Metallschicht und die freiliegenden Oberflächen der Metallsäule werden bis zur Aufdeckung der ersten Photoresistlackschicht geätzt;

- die erste Photoresistlackschicht wird entfernt.

Das erfindungsgemäße Verfahren führt zu einer Gate-Metall-Säule, die sich von dem Gate-Gebiet mit Abstand durch die Öffnung oder das Fenster erstreckt, das durch die benachbarten Drain- und Source-Metallschichten offengelassen wird. Kurzschlüsse werden daher vermieden. Erforderlichenfalls kann das obere Ende der Metallsäule zu einer Gatefläche geformt werden. Dies wird dadurch erreicht, daß man den Elektroplattiervorgang weiterführt, bis die Metallsäule über die äußere Photoresistlackschicht hinausragt. Im übrigen wird jede Schicht auf den ohmschen Inseln in gesonderten Schritten entfernt, d.h. ohne Benutzung von Abhebetechniken.

Das erfindungsgemäße Verfahren eignet sich insbesondere zur Herstellung miniaturisierter Feldeffekttransistoren und erlaubt die Abscheidung beträchtlicher Mengen des Gate-Metalls. Außerdem können je nach Wunsch unterschiedliche Gate-Metall-Systeme Verwendung finden.

Ferner läßt sich eine unsymmetrische Anordnung des Gates zwischen Source und Drain in verhältnismäßig einfacher Weise erzielen. Vorzugsweise wird die erste Photoresistlackschicht derart belichtet und geätzt, daß das Gate-Gebiet näher an Source als an Drain zu liegen kommt.

Die erste Photoresistlackschicht kann ferner vorteilhaft derart geätzt werden, daß ihre Wände am Gate-Gebiet eine positive Neigung erhalten.

Zur Herstellung der Schottky-Metallschicht eignet sich vorzugsweise temperaturbeständiges Metall.

Um eine gleichmäßige Abscheidung zu erzielen, kann die Schottky-Metallschicht ferner vorteilhaft mittels einer Planetenbedampfungsanlage aufgebracht werden.

Im folgenden wird die Erfindung anhand der Figuren im einzelnen erläutert, die Querschnitte durch einen FET während verschiedener Stufen des Herstellungsverfahrens darstellen. Im einzelnen zeigen

Figur 1 den Zwischenzustand einer FET-Struktur, nachdem das Halbleitersubstrat vorbereitet und die ohmsche Metallschicht darauf abgeschieden ist;

Figur 2 die gleiche Struktur nach Bildung des Kanals;

Figur 3 die Struktur nach Aufbringen der ersten Photoresistlack-Maske;

Figur 4 die Struktur nach der Erzeugung einer Schottky-Metall-Schicht auf den offenliegenden Oberflächen;

Figur 5 die Struktur nach der zweiten Maskierung und Ätzung;

Figur 6 die Struktur nach Bildung der sich vom Gate-Gebiet aus erstreckenden Metallsäule;

Figur 7 die Struktur nach Ablösung der zweiten Photoresistlack-Maske;

Figur 8 die Struktur nach Ätzung der Schottky-Metallschicht und

Figur 9 schließlich den fertigen FET nach Entfernung der ersten Photoresistlack-Maske.

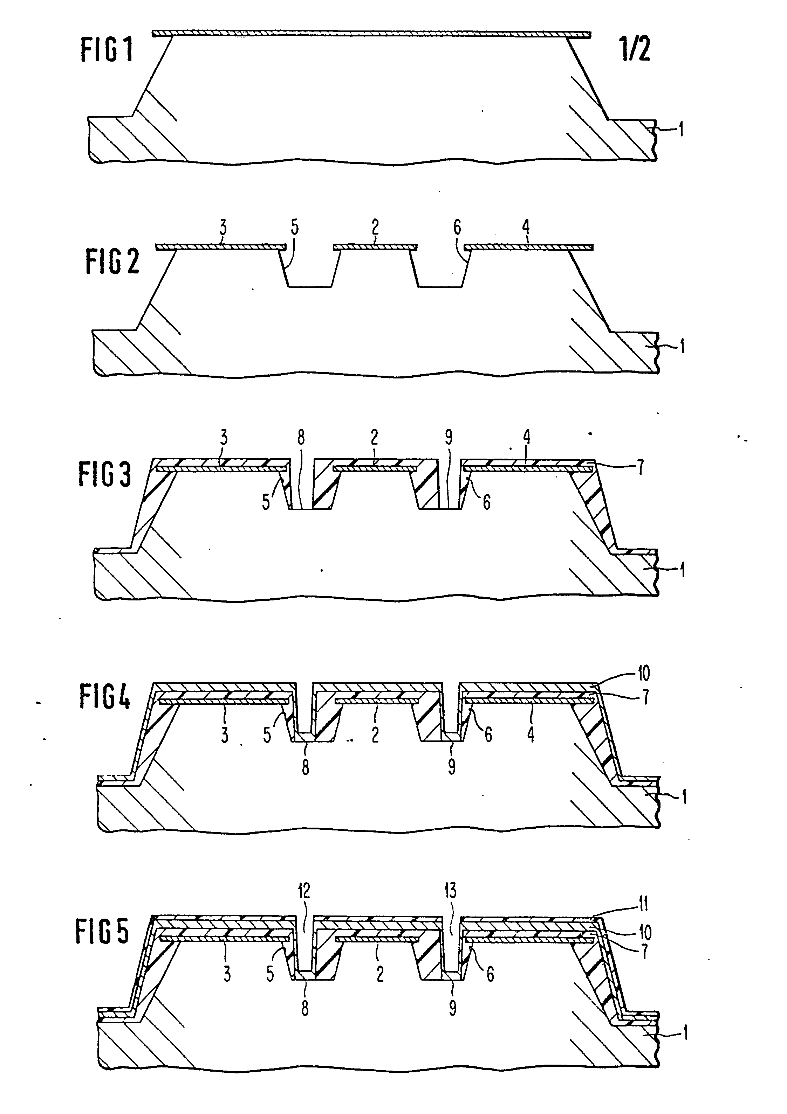

Im folgenden soll ein bevorzugtes Ausführungsbeispiel näher beschrieben werden. Entsprechend den Figuren 1 und 2 wird ein Halbleitersubstrat 1, vorzugsweise aus GaAs, geeignet dotiert, dann mit einer Schicht aus ohmschem Metall, beispielsweise einem Au-Ge-Eutektikum mit Nickel-Deckschicht,bedeckt, wobei diese Schicht eine Dicke zwischen $1 \cdot 10^{-8}$ bis $3000 \cdot 10^{-8}$ cm hat, und wird anschließend mit einem Mesa-Profil versehen. Die Dotierung kann vom n-Typ mit einer Dotierungsdichte sein, die von etwa $5 \cdot 10^{18}$ cm$^{-3}$ (n$^+$) in der äußersten Substratschicht auf etwa $8 \cdot 10^{16}$ cm$^{-3}$ (n) in der nächsten Schicht abnimmt und dann auf weniger als $10^{13}$ cm$^{-3}$ in der sogenannten Puffer-Schicht abfällt. Die (Seiten-) Täler des Mesa-Profils liegen in der Puffer-Schicht. Wie die Figuren zeigen, hat jede Mesa ein zentrales, mit einer ohmschen Drain-Metallschicht 2 bedecktes Drain und zwei Sources, die jeweils von einer ohmschen Source-Metallschicht 3 bzw. 4 bedeckt sind. Das zentrale Drain wird von den Sources durch Kanäle 5 bzw. 6 getrennt. Die Kanäle sind etwa 0,5 bis 1,5 μm tief, etwa 3 bis 6 μm breit, 50 bis 250 μm lang und erstrecken sich bis zu der n-dotierten Substratschicht. Zur Bildung von Source und Drain können alle bekannten Verfahren, beispielsweise Abhebe- oder Ionenätztechniken, verwendet werden und die Kanäle können beispielsweise durch Naßätzen gebildet werden. Alle diese Verfahren gehören zum Stand der Technik und brauchen hier daher nicht im einzelnen beschrieben zu werden.

Nach Bildung der Kanäle wird das gesamte Gebilde mit einer positiven Photoresistlackschicht 7 überzogen, die wiederum mit einer nicht dargestellten Maske bedeckt wird, welche die vorbestimmten Gate-Gebiete unbedeckt läßt. Nachdem der Wafer aktivierendem Licht ausgesetzt wurde, die Maske entfernt und die dem Licht ausgesetzten Photoresistlack-Gebiete aufgelöst sind, sind die Gate-Gebiete 8 und 9 definiert. Falls erwünscht, können diese Gebiete zusätzlich geätzt werden. Die Neigung der Photoresistlackwände ist nicht kritisch, es kann jedoch erwünscht sein, eine positive Neigung der Wände zu erzielen, wie dies in Figur 3 dargestellt ist.

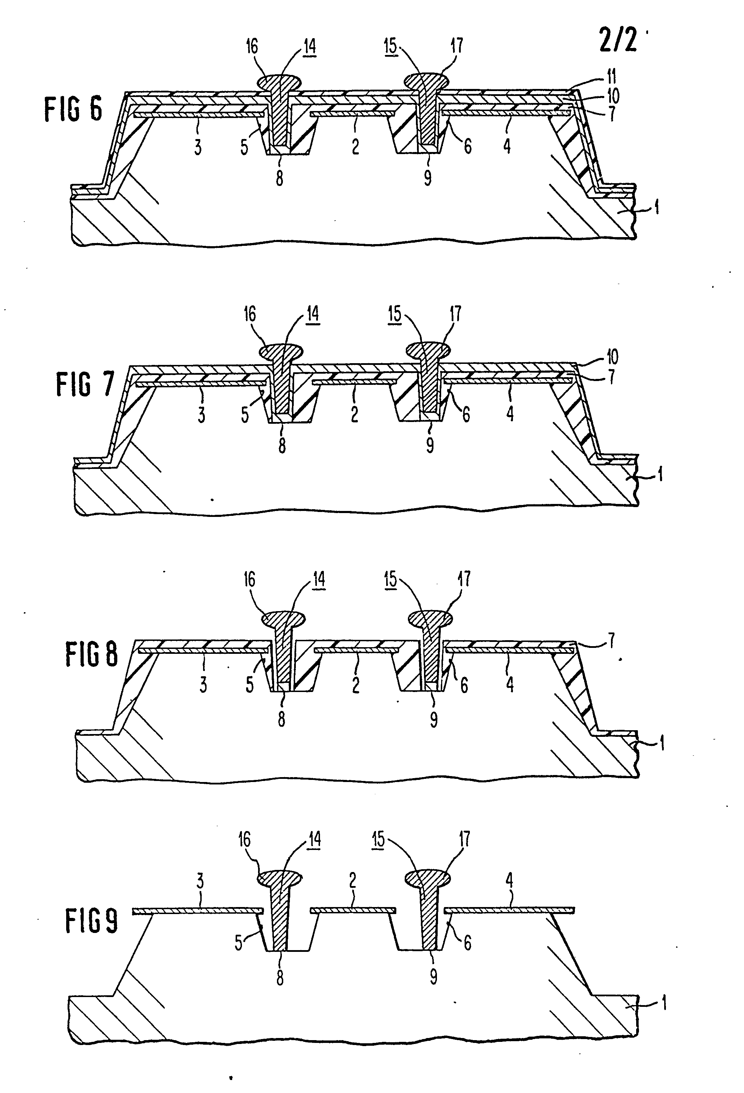

Der nächste, in Figur 4 dargestellte Schritt besteht im Aufdampfen einer Metallschicht 10, die auf dem Halbleitersubstrat einen Schottky-Kontakt bildet. Die Schottky-Kontakt-Schicht ist vorzugsweise eine Schichtanordnung aus temperaturbeständigem Metall, beispielsweise von unten nach oben Titan, Platin und Gold. Die Schicht 10 wird mit Hilfe einer Planetenbedampfungsanlage abgeschieden, wodurch eine gute Bedeckung der geneigten Photoresistlackwände erzielt wird. (Bei einer sogenannten Planetenbedampfungsanlage rotieren die in der Regel mehrere Halbleiterscheiben aufnehmenden Substrathalterungen um ihre eigene Achse und um eine weitere Achse im Bedampfungsgefäß.)

Nach der Metallisierung wird eine zweite Photoresistlack-Maske 11 auf der Schottky-Metallschicht 10 erzeugt. Diese Maske wird mit Fenstern 12 und 13 versehen, die jeweils auf das zugehörige Gate-Gebiet ausgerichtet sind (vgl. Figur 5). Anschließend wird elektroplattiert, vorzugsweise mit Hilfe eines handelsüblichen Goldbades. Dabei wird das Metall nur in dem offenen, durch die Fenster 12 und 13 bestimmten Gebiet abgeschieden. Nachdem die Metallabscheidung, die etwa zylinderförmige Metallsäulen 14 und 15 mit vergrößertem Kopfteil bildet, die gewünschte Höhe erreicht hat, wird der Elektroplattierprozeß beendet. Es ist anzumerken, daß das Metall praktisch bis zu jeder beliebigen Höhe plattiert und ebenso eng an die Source herangebracht werden kann, wie dies mit den an sich bekannten Techniken möglich ist. Beim vorliegenden Beispiel haben die Säulen eine Dicke von etwa 4 /um in der Zeichenebene und sind wenigstens

3 $\mu$m hoch. Dies kann durch ein übliches Elektroplattierverfahren mit einer Stromdichte von etwa 2,15 mA/cm$^2$ und
mit einer Plattierrate von etwa 13 . 10$^{-8}$ cm/min
erreicht werden. Die Abstände zwischen den Säulen 14
und 15 und der Drain-Metallschicht 2 sowie den Source-
Metallschichten 3 und 4 betragen etwa 4 $\mu$m bzw. 1 $\mu$m.
Wie man aus Figur 6 erkennt, erstrecken sich die Metallsäulen 14 und 15 durch die Ebene des ohmschen Metalls
und enden in vergrößerten Kopfteilen 16 und 17, die als
Gate-Kontaktflächen dienen.

Anschließend wird die Photoresistlackmaske 11 entfernt
(Figur 7) und die aufgedampfte Metallschicht freigelegt.
Alle Metalle werden nun gleichzeitig mit der gleichen
Ätzrate geätzt, bis das nichtplattierte Metall, z. B.
durch Ionenätzen im Vakuum innerhalb etwa 20 Minuten,
bis zur Maske 7 abgeätzt ist (Figur 8). Schließlich
wird die Photoresistlackmaske 7 aufgelöst. Die fertige
Struktur ist in Figur 9 dargestellt.

Gegenüber dem vorstehend erläuterten bevorzugten Aus--
führungsbeispiel sind zahlreiche Abwandlungen und
Änderungen möglich, ohne den Rahmen des erfindungsgemäßen
Verfahrens zu überschreiten.

Patentansprüche

1. Verfahren zum Herstellen eines Feldeffekttransistors mit einem Halbleitersubstrat, das Source und Drain, jeweils mit einer ohmschen Metallschicht bedeckt, einen Kanal zwischen diesen und ein Gate innerhalb des Kanals aufweist; g e k e n n z e i c h n e t   durch folgende Schritte:

- nach Bildung von Source (3, 4) und Drain (2) mit der ohmschen Metallschicht sowie des Kanals (5, 6) wird eine erste Photoresistlackschicht (7) aufgebracht, das Gate-Gebiet (8, 9) innerhalb des Kanals (5, 6) photolithographisch festgelegt und die Photoresistlackschicht (7) innerhalb des Gate-Gebietes (8, 9) abgeätzt;

- alle offenliegenden Oberflächen werden mit einer Schottky-Metallschicht (10) beschichtet;

- auf die Schottky-Metallschicht (10) wird eine zweite Photoresistlackschicht (11) aufgebracht;

- in der zweiten Photoresistlackschicht (11) wird im Kanal (5, 6) photolithographisch eine auf das Gate-Gebiet (8, 9) ausgerichtete Gate-Öffnung (12, 13) festgelegt und die Photoresistlackschicht (11) dort abgeätzt;

- durch Elektroplattieren des Halbleitersubstrats (1) wird auf der Schottky-Metallschicht (10) innerhalb des Gate-Gebietes (8, 9) eine Metallsäule (14, 15) gebildet;

- die zweite Photoresistlackschicht (11) wird abgelöst;

- die Schottky-Metallschicht (10) und die freiliegenden Oberflächen der Metallsäule (14, 15)
werden bis zur Aufdeckung der ersten Photoresistlackschicht (7) geätzt;

- die erste Photoresistlackschicht (7) wird
entfernt.

2. Verfahren nach Anspruch 1, d a d u r c h   g e -
k e n n z e i c h n e t, daß die erste Photoresistlackschicht (7) derart belichtet und geätzt wird, daß das Gate-Gebiet
(8, 9) näher an Source (3, 4) als an Drain (2) zu
liegen kommt.

3. Verfahren nach Anspruch 1 oder 2, d a d u r c h
g e k e n n z e i c h n e t, daß die erste Photoresistlackschicht (7) derart geätzt wird, daß ihre Wände
am Gate-Gebiet (8, 9) eine positive Neigung erhalten.

4. Verfahren nach einem der Ansprüche 1 bis 3, d a -
d u r c h   g e k e n n z e i c h n e t, daß die
Schottky-Metallschicht (10) aus temperaturbeständigem
Metall hergestellt wird.

5. Verfahren nach einem der Ansprüche 1 bis 4, d a -
d u r c h   g e k e n n z e i c h n e t, daß die
Schottky-Metallschicht mittels einer Planetenbedampfungsanlage hergestellt wird.

6. Verfahren nach einem der Ansprüche 1 bis 5, d a -
d u r c h   g e k e n n z e i c h n e t, daß das
Halbleitersubstrat (1) so lange elektroplattiert wird,
bis die Metallsäule (14, 15) ein verbreitertes Kopfteil
(16, 17) aufweist.

FIG 1

FIG 2

FIG 3

FIG 4

FIG 5

FIG 6

FIG 7

FIG 8

FIG 9